# EUROPEAN PATENT APPLICATION

(11) **EP 2 768 143 A1**
(43) Date of publication of application: **20.08.2014**
(21) Application number: 13155546.8
(22) Date of filing: 15.02.2013
(51) Int. Cl.: H03M 1/12

(54) **Circuit and method for digitizing analogue signals**

(71) Applicant: IMEC, 3001 Leuven (BE)
(72) Inventor: Mitra, Srinjoy, 3001 Leuven (BE)
(74) Representative: Clerix, André

(57) **Abstract**

The invention relates to a circuit (10) for digitizing at least one analogue signal (AI), comprising: a sample and hold module (100) configured for sampling the at least one analogue signal (AI) and storing a plurality of said sampled values (H1 to H5); an analog-to-digital conversion module (150) configured for performing an analogue-to-digital conversion of the sampled values (H1 to H5) provided by the sample and hold module (100); wherein the sample and hold module (100) is further configured for providing to the analogue-to-digital conversion module (150) the stored sampled values (H1 to H5) in a first-input-first-output sequence; and the circuit (10) further comprises a signal threshold detection module (120) configured for detecting whether any of the stored sampled values (H1 to H5) reaches or surpasses a certain threshold value (ThA) and generating a signal to activate the analog-to-digital conversion module (150) when said threshold is detected.

The invention also relates to a method for converting at least one analogue signal (AI) into a digital signal (DO).

## Description

### Technical Field

The present invention relates generally to the field of analogue-to digital conversion and more specifically to a circuit and method for digitizing analogue signals in event-driven data acquisition scenarios.

### Background

State of the art digital signal processing and microprocessor systems and applications usually require the digitization of information, received by means of analogue signals, in order to analyse and process that information in the digital domain. In order to digitize those analogue input waveforms, state of the art solutions commonly use on or a plurality of Sample-and-Hold (S/H) circuits followed by one or more analogue-to-digital converters (ADC).

In some type of applications, which involve analogue "bursty" signals with varying activity over time, possibly including long periods of silence, it is advantageous to use event-based sampling techniques, in which a sample is produced only when something significant (an "event") occurs in the signal. An overview of such techniques is provided, for example, in article "Event-Driven Data Acquisition and Digital Signal Processing-A Tutorial", by Tsividis, Y., Circuits and Systems II: Express Briefs, IEEE Transactions on, Issue Date: Aug. 2010.

Another known technique for digitizing analogue information when a trigger signal is generated, is disclosed in article *"*The Large Analog Bandwidth Recorder and Digitizer with Ordered Readout (LABRADOR) ASIC", by G.S. Varner et al., Nuclear Instruments and Methods in Physics Research, Section A: Accelerators, Spectrometers, Detectors and Associated Equipment, Volume 583, Issues 2-3, 21 December 2007, pages 447-460. The article describes an analogue waveform recorder using a switched capacitor array (SCA) comprising an array of Sample-and-Hold (S/H) circuits. In a specific embodiment, eight RF input channels are each sampled by an array of 256 SCA storage cells. Sampling occurs continually until a trigger signal is generated, at which point the analogue samples are held and not overwritten. These stored values are then selected and transferred off-chip for external ADC conversion.

### Summary

According to one aspect of the present disclosure, a new circuit and method for digitizing at least one analogue signal is provided. Said circuit and method for digitizing analogue signals according to the present invention is advantageously suitable for event-driven data acquisition systems and applications in which only parts of the analogue input waveforms are of interest for analysis and processing, and therefore only those parts of the analogue input waveforms need to be encoded digitally. Examples of such event-driven data acquisition systems and applications may be, but not limited to, biomedical systems in which there is a need to digitize and analyse biopotential signals such as, for example, electrocardiogram signals, or neural recording systems in which there is a need to identify neural action potential (AP) signals. Such type of analogue signals are characterized by periods in which there is a certain kind of "activity" (or event) that the circuit or system would like to identify and process, while the other periods of the analogue signal may either not be relevant for the application or the signal presents no activity.

According to one or more embodiments of the present invention, the circuit and method for digitizing analogue signals herein described advantageously reduces electrical power consumption. Also according to one or more embodiments of the present invention, the circuit and method for digitizing analogue signals herein described advantageously reduces circuit complexity.

According to an exemplary embodiment of the invention, there is provided a circuit for digitizing at least one analogue signal, comprising: a sample and hold module configured for sampling the at least one analogue signal and storing a plurality of said sampled values; an analog-to-digital conversion module configured for performing an analogue-to-digital conversion of the sampled values provided by the sample and hold module; wherein the sample and hold module is further configured for providing to the analogue-to-digital conversion module the stored sampled values in a first-input-first-output sequence; and the circuit further comprises a signal threshold detection module configured for detecting whether any of the stored sampled values reaches or surpasses a certain threshold value and generating a signal to activate the analog-to-digital conversion module when said threshold is detected.

According to an exemplary embodiment, the sampled values provided by the sample and hold module for analogue-to-digital conversion represent a delayed quantized signal version of the at least one analogue signal.

According to an exemplary embodiment, the sample and hold module may be configured to continuously sample and store the sampled values of the at least one analogue signal.

According to an exemplary embodiment, the signal threshold detection module may be further configured for generating an indication to deactivate the analogue-to-digital conversion module and stop conversion.

According to an exemplary embodiment, the signal threshold detection module may comprise a comparator for comparing the stored sampled values with the threshold value.

According to an exemplary embodiment, the stored sample values in the sample and hold module may be connected to the signal threshold detection module by means of a multiplexer circuit.

According to an exemplary embodiment, the sample and hold module may comprise at least one sampling arrangement configured as an analogue FIFO.

According to an exemplary embodiment, the at least one sampling arrangement may comprise a first set and a second set of switching elements which are controlled by switching control signals that trigger those switching elements in a sequential manner.

According to an exemplary embodiment, the sample and hold module may comprise a plurality of sampling arrangements, each receiving a different input analogue signal to be digitized and the circuit being configured for interleaving in time the sampled analogue values provided to the signal threshold detection module and to the analogue-to-digital conversion module.

The invention also relates to an electronic system comprising a circuit for digitizing at least one analogue signal according to any of the embodiments herein described.

According to another exemplary embodiment, there is provided a method for converting at least one analogue signal into a digital signal, comprising: in a sample and hold module, sampling the at least one analogue signal, storing a plurality of said sampled values and providing to an analogue-to-digital conversion module the stored sampled values according to a first-input-first-output sequence; in a signal threshold detection module, detecting whether any of the stored sampled values reaches or surpasses a certain threshold value and generating a signal to activate the analogue-to-digital conversion module when said threshold is detected; and in the analogue-to-digital conversion module, activating conversion circuitry and performing the analogue-to-digital conversion of the received sampled values when an activation signal is received from the signal threshold detection module.

According to another exemplary embodiment, the sampling of the at least one analogue signal and the storing of the sampled values may be performed continuously.

According to another exemplary embodiment, the method may further comprise: in the signal threshold detection module, generating an indication to deactivate the analogue-to-digital conversion module and stop conversion: and in the analogue-to-digital conversion module, deactivating conversion circuitry when an activation signal is received from the signal threshold detection module.

According to another exemplary embodiment, the method may comprise: in the sample and hold module, sampling a plurality of analogue signals; and interleaving in time the sampled analogue values provided to the signal threshold detection module and to the analog-to-digital conversion module.

According to an exemplary embodiment of the present invention, the fact that we are interested only in a certain kind of activity (or window) of the entire analogue signal is advantageously exploited. The solution according to an exemplary embodiment is suited for certain applications which requires a delayed digitization of analogue signals, for example, neural action potential signals. According to an exemplary embodiment of the invention, the solution is also advantageously suited for Action Potential (AP) signal detection in tetrode-based (four closely placed electrodes) neural interface recording systems. The technique may be also applied, for example, with poly-trodes configurations where more than one electrode receives correlated signal from the same neuron. Advantageously, the proposed solution, according to an exemplary embodiment, can lead to significant power saving without any distortion to the original analogue signal or signals. Also advantageous is the fact that a certain number of "pre-trigger" data samples is digitized. According to an exemplary embodiment of the invention, a method is proposed where the digitization of the neural recording is initiated (ADC is powered on) only when there is threshold crossing, but the actual data transmitted consists of a period even before the crossing happens. This fraction of data (the pre-trigger data) is of particular importance to preserve the integrity of the analogue signal shape and thus perform better post digitization analysis (e.g. spike sorting of AP signals). The proposed solution, according to an exemplary embodiment, is even more useful for data recorded in a tetrode configuration, where each of the electrodes picks up a slightly delayed version of a single AP signal. According to another exemplary embodiment, each tetrode configuration may have different programmable thresholds and the ADC is triggered if any one of them is crossed, which provides the possibility to capture even more pre-trigger samples for the electrodes that received a delayed version of the same AP, which enhances spike sorting.

According to an exemplary embodiment of the present invention, by using a method based on just analogue signal event activity (e.g. AP activity), the data digitized and gathered for post processing purposes can be considerably reduced. In spite of large data compression, the present technique accurately preserves the analogue signal shape, essential for further digital processing (e.g. spike sorting). For example, a typical AP signal has distinctive features even before it crosses a given voltage threshold. This shape can be preserved only if both the pre-trigger and the post-trigger samples are provided to the ADC for conversion. The analog data can be delayed and the relevant segments digitized and transmitted after detection. Since all functional blocks from ADC onwards can be power gated, the present technique has the potential to reduce the system power consumption to its absolute minimum when there is no analogue signal activity.

According to another exemplary embodiment of the invention, it is provided an improved circuit and method for digitizing at least one analogue signal with no additional power consumption and yet accurately preserving pre-and post-triggered data. Advantageously, the solution according to an exemplary embodiment does not discard all the relevant data before the threshold crossing (indicating the activity or event that has to be digitized) of the analogue signal. The proposed solution according to an exemplary embodiment also advantageously avoids delaying the analogue signal with a constant group delay filter that requires complex circuits and introduces considerable distortion of the input analogue signal wave shape. The proposed solution according to an exemplary embodiment also avoids continuous and unnecessary digitization of the analogue signal and on-chip buffering of that digitized data.

Certain objects and advantages of various new and inventive aspects have been described above. It is to be understood that not necessarily all such objects or advantages may be achieved in accordance with any particular embodiment of the present invention. Those skilled in the art will recognize that the solution of the present invention may be embodied or carried out in a manner that achieves or optimizes one advantage or group of advantages without necessarily achieving other objects or advantages.

### Brief description of the drawings

The above and other aspects of the circuit and method for digitizing an analogue signal according to the present invention will be shown and explained with reference to the non-restrictive example embodiment(s) described hereinafter.

**Figure 1** shows an exemplary block diagram of a circuit for digitizing an analogue signal according to an embodiment of the invention.

**Figure 2** shows an analogue Sample-and-Hold circuit according to an exemplary embodiment of the invention.

**Figures 3A and 3B** illustrate schematically the graph of the signals at the input and the output of the Sample-and-Hold circuit according to another exemplary embodiment of the invention.

**Figure 4** shows a schematic block diagram of a specific part of the circuit for digitizing an analogue signal according to another exemplary embodiment of the invention.

**Figure 5** illustrates an exemplary timing diagram and output time slots of the circuit shown in **Figure 4** according to another exemplary embodiment of the invention.

### Detailed description

In the following, in the description of exemplary embodiments, various features may be grouped together in a single embodiment, figure, or description thereof for the purpose of streamlining the disclosure and aiding in the understanding of one or more of the various inventive aspects. This is however not to be interpreted as the invention requiring more features than the ones expressly recited in the main claim. Furthermore, combinations of features of different embodiments are meant to be within the scope of the invention, as would be clearly understood by those skilled in the art. Additionally, in other instances, well-known methods, structures and techniques have not been shown in detail in order not to obscure an understanding of the description.

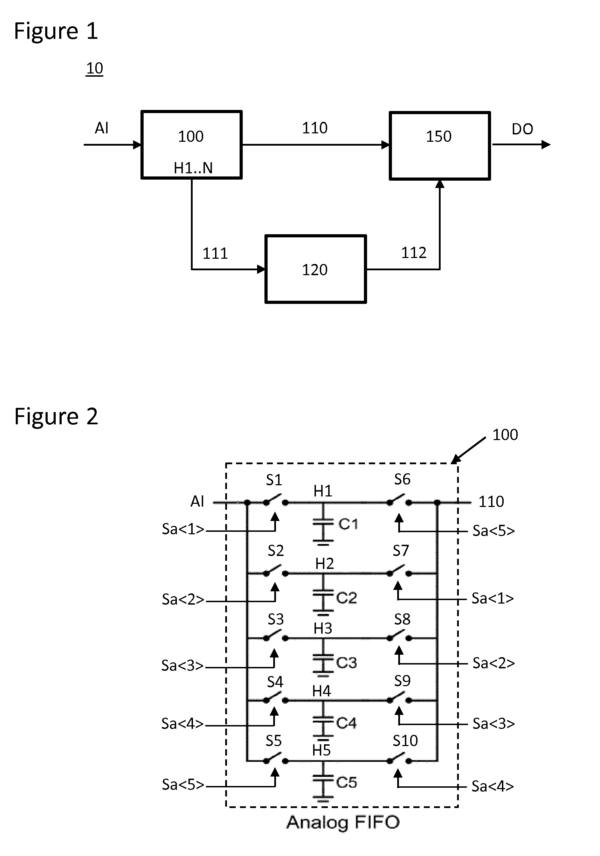

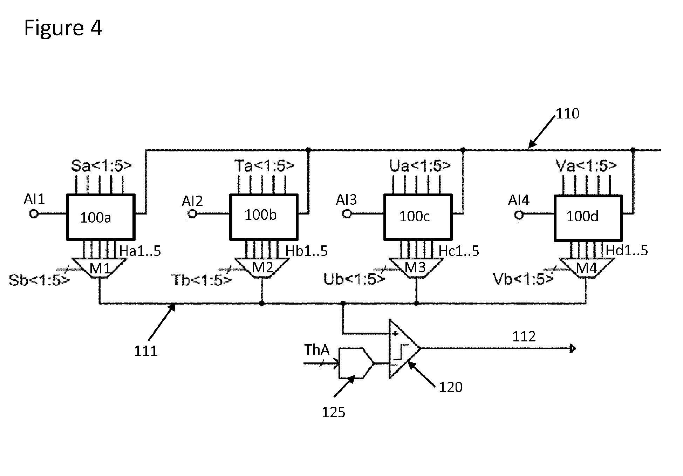

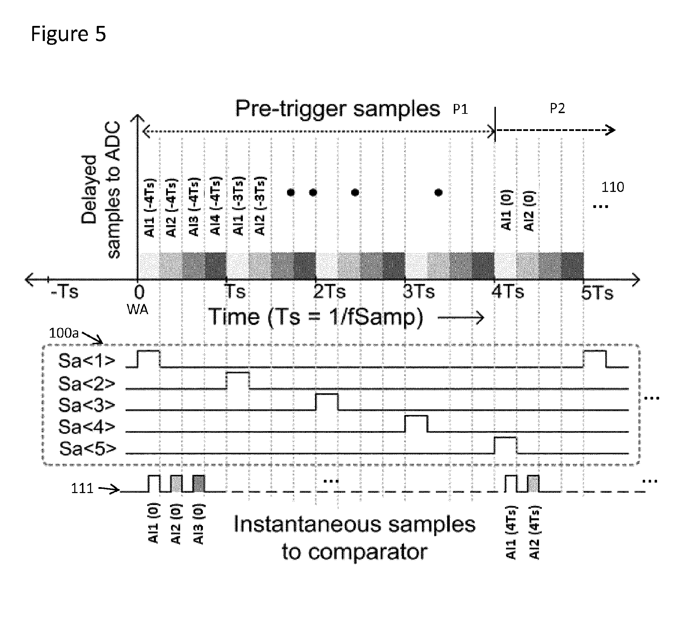

**Figure 1** shows a general exemplary block diagram of a circuit **10** for digitizing at least one analogue signal **Al** according to an exemplary embodiment of the invention. For the sake of simplicity and understanding, the circuit of **Figure 1** will be explained in the following for just one analogue signal input **Al,** while an exemplary embodiment for a plurality of input analogue signals **Al1** to **Al4** is explained in **Figures 4** and **5****.**

The circuit **10** comprises a S/H module **100,** a signal threshold detection module **120** and an ADC module **150.** The S/H module **100** receives the at least one analogue signal **Al,** samples said analogue signal, stores said sampled values in a plurality of internal memory elements and provides those stored values, through a first connection **110,** in a first-input-first-output sequence to the ADC **150.** The provided sampled values at the first connection **110,** represent, according to an embodiment of the invention, a delayed quantized signal version of the analogue signal **Al.** The S/H module **100** also provides, through a second connection **111,** the values **H1..N** stored in the internal memory cells to the signal threshold detection module **120.** In case the signal threshold detection module **120** detects that any of those values **H1..N** reaches or surpasses a certain threshold value, it generates an activation or wake up signal for the ADC **150,** which activates the ADC module and triggers the conversion of the quantized signal received from the S/H module **100.** Said activation signal can be provided, for example, through a third connection **112.** The ADC output **DO** is therefore, according to an exemplary embodiment of the invention, the digital version of the quantized signal received through the first connection **110.** Advantageously, according to an embodiment of the invention, the ADC **150** does not consume or consumes a limited amount of electrical power until it is activated by the signal threshold detection module **120.** According to an embodiment of the invention, the ADC **150** does not perform any analogue-to-digital conversion until it is activated by the signal threshold detection module **120.** According to another embodiment of the invention, the signal threshold detection module **120** may also indicates to the ADC **150** the analogue-to-digital conversion period and/or when the ADC **150** shall go again to no conversion mode with no or limited power consumption. According to another exemplary embodiment of the invention, when the signal threshold detection module **120** detects that the stored sampled values **H1..N** go under a certain second threshold value, it generates a signal to deactivate or turn off the ADC in order to save power.

**Figure 2** shows an analogue S/H module **100** comprising one analogue FIFO arrangement according to an exemplary embodiment of the invention. An exemplary embodiment of an analogue S/H module **100** comprising a plurality of analogue FIFO arrangements **100a** to **100d** is shown in **Figure 4****.**

The S/H module **100** shown in **Figure 2** is implemented as an analogue first-input-first-output (FIFO) memory arrangement and comprises a plurality of switching elements **S1** to **S10** being controlled by a plurality of switching control signals **Sa<1>** to **Sa<5>.** The analogue FIFO memory arrangement also comprises a plurality of memory cells **C1** to **C5** for storing sampled values **H1** to **H5** of the analogue signal. The voltage values **H1** to **H5** of the memory cells **C1** to **C5** are first stored by a first set of switching elements **S1** to **S5,** and then passed to the first connection line **110** by activating a second set of switching elements **S6** to **S10** according to a first-input-first-output sequence. The switching control signals **Sa<1>** to **Sa<5>** activate the first set of switching elements **S1** to **S5** so that samples of the input analogue signal **Al** are stored sequentially in the memory cells **C1** to **C5** and activate the second set of switching elements **S6** to **S10** also sequentially, in a FIFO manner, to pass the voltage values **H1** to **H5** to the first connection line **110.** In a certain manner, the analogue FIFO arrangement according to the invention, could be understood as a circular memory arrangement, in which the output voltage samples at the first connection line **110** are the samples of the input analogue signal **Al** taken by the first set of switching elements **S1** to **S5** but delayed by a certain number of sampling periods. An exemplary timing diagram for those switching control signals **Sa<1>** to **Sa<5>** and how some of the sampled voltage values **Al1 (nTs)** are passed to the ADC can be seen in **Figure 5****,** related to a first analogue FIFO circuit **100a.** It is understood that the switching elements S1 to **S10** can be implemented in a plurality of manners known by the persons skilled in the art, as long as they provide a switching functionality. The same reasoning applies for the memory cells **C1** to **C5,** which do not have to necessarily be implemented as capacitors, since it is understood that any memory element that can store a sampled voltage value would be applicable according to the present description.

Additionally, according to an embodiment of the invention, the sampled voltage values **H1** to **H5,** when stored in the memory cells, are also provided to the signal threshold detection module **120** through the second connection **111,** so that the signal threshold detection module **120** detects whether any of those stored values reaches or surpasses a certain threshold value. An exemplary timing diagram showing when said sampled values **Al1 (Ts)** are passed to the signal threshold detection module **120** can be seen in **Figure 5****,** related to a first analogue FIFO circuit **100a.** It is understood that the voltage values **H1** to **H5** of the memory cells can be connected in any manner to the signal threshold detection module **120,** and one example may be by means of a multiplexer circuit.

In general, more switches can be added to the analogue FIFO arrangement in order to gather more pre-triggered samples. Care shall be taken though with the parasitic capacitance that could distort the sampled signal.

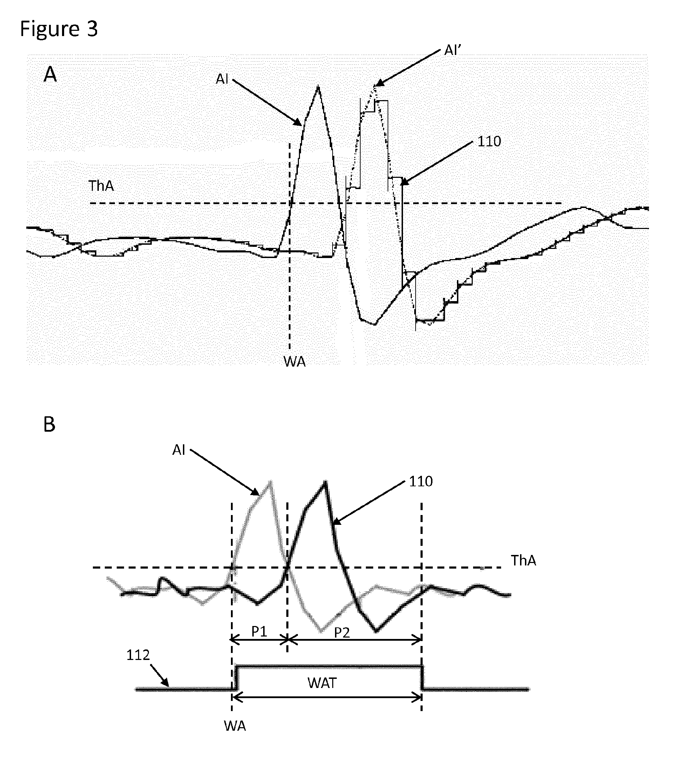

**Figures 3A and 3B** illustrate schematically the graph of the signals at the input and the output of the S/H circuit **100** shown in **Figure 2** according to an exemplary embodiment of the invention. **Figure 3A** shows the analogue signal **Al** received at the input of the S/H circuit **100** and the quantized signal provided at the output, to the first connection line **110.** As can be seen in **Figure 3A****,** the signal at the first connection line **110** is the result of sampling, according to the shown S/H arrangement, an ideal delayed version **Al'** of the input analogue signal **Al.**

According to an exemplary embodiment of the invention, the signal threshold detection module **120** is configured to detect, at a certain threshold trigger point **WA,** whether any of the sampled values **H1** to **H5** of the input analogue signal **Al** reaches or surpasses a certain threshold value **ThA.** Said sampled version of the input analogue signal **Al** is not shown in **Figure 3A****,** and is simplified by just showing the threshold value **ThA** over the input analogue signal **Al,** but it is understood that it is the same as the one provided to the first connection line **110** without the delay introduced by the analogue FIFO arrangement of the S/H module **100.**

**Figure 3B** is also a schematic graphical simplification of the operation of the S/H circuit **100** shown in **Figure 2****.** It will be understood that, when the signal threshold detection module **120** detects that any of the sampled values **H1** to **H5** of the input analogue signal **Al** reach or surpass a certain threshold value **ThA** at a certain threshold trigger point **WA,** said signal threshold detection module **120** generates an activation or wake up signal **112** for the ADC module **150.** When activated by the signal threshold detection module **120,** the ADC **150** will start the analogue-to-digital conversion of the quantized signal at the first connection line **110.** Advantageously, due to the S/H module arrangement according to the invention, the ADC **150** is able to digitize a certain number of pre-trigger values **P1** of the input analogue signal **Al.** According to an embodiment of the invention, the ADC **150** will continue the analogue-to-digital conversion of a certain number of post-trigger values **P2** of the input analogue signal **Al,** for a predetermined time or until the signal threshold detection module **120** indicates that the conversion shall be finished. The analogue-to digital conversion period **WAT** of the ADC **150** may therefore be predetermined or dynamically indicated by the signal threshold detection module **120.**

**Figure 4** shows a schematic block diagram of another exemplary embodiment of the S/H module **100** and the signal threshold detection module **120** of **Figure 1****.** The S/H module **100** comprises four analogue FIFO arrangements **100a** to **100d** according to the circuit shown in **Figure 2****.** Each analogue FIFO arrangement receives one input analogue signal **Al1** to **Al4** and the output is connected to the first connection line **110** to the ADC **150.** According to an exemplary embodiment of the invention, the output values **Aln (nTs)** of each analogue FIFO arrangement **100a** to **100d** are interleaved at the first connection line **110,** as can be appreciated in **Figure 5****,** due to configured sampling slots indicated by the switching control signals **Sa<1:5>** to **Va<1:5>.** The voltage values **Ha1..5** to **Hd1..5** of the analogue FIFO memory cells, resulting from the sampling of the input analogue signals **Al1** to **Al4** by the first set of switching elements **S1** to **S5** (as shown in **Figure 2****)** are connected, by means of corresponding multiplexer circuits **M1** to **M4** to the signal threshold detection module **120,** through the second connection **111.** The multiplexer circuits **M1** to **M4** are controlled by corresponding multiplexer control signals **Sb<1:5>** to **Vb<1:5>.** According to an exemplary embodiment of the invention, the signal threshold detection module **120** may comprise a comparator circuit, configured for comparing the values at the output of the multiplexers **M1** to **M4** with a certain threshold value **ThA,** but it is understood that another means for comparison of those values may be used. According to an exemplary embodiment of the invention the threshold value **ThA** may be a digital value which is adapted by a digital-to-analogue circuit at the input of the comparator. It is understood that that threshold value **Tha** (or any other needed) may be fixed or dynamically changing according to the system needs and can be received by the circuit or calculated in another module. According to an exemplary embodiment of the invention, the output of the comparator **120** is an activation signal connected to the ADC **150** by means of the third connection **112.** It shall also be noted that the threshold value **ThA** does not need to be one single value, and the circuit may have different thresholds for different sampling arrangements.

Advantageously, according to an exemplary embodiment of the invention, the circuit **10** (general block diagram shown in **Figure 1****)** can be used to digitize two or more analogue signals in event-driven data acquisition scenarios. The proposed solution advantageously reduces power consumption, circuit complexity, circuit area and/or cost.

**Figure 5** illustrates an exemplary timing diagram and output time slots of the circuit shown in **Figure 4** according to another exemplary embodiment of the invention. The figure shows the relationship between the switching control signals **Sa<1:5>** to **Va<1:5>** (specific timing diagrams for switching control signals **Ta<1:5>, Ua<1:5>** and **Va<1:5>** are not shown, but ca be inferred from the position of the switching control signals **Sa<1:5>)** and the corresponding sampled values at the first connection **110** and the second connection **111.** As can be seen, while the values of the samples at the second connection **111** are the present sampled values of the analogue signal **Aln (nTs),** i.e. correspond to the sampled values **Ha1..5** to **Hd1..5** of the analogue FIFO memory cells in **Figure 4****,** the values at the first connection **110** are the pre-trigger sampled values (four pre-trigger sampled values in this exemplary embodiment), so that these values are not lost when digitizing the window of interest of the input analogue signal **Aln.**

Further advantageous embodiments of the invention will be described below. For example, neuroscience research and BMI (Brain machine interface) devices require large number of electrodes to simultaneously record and transmit biopotential events from several neurons in the cortex, and yet consume very low power. Since infrequent Action Potentials (APs, 50-100Hz) are considered to be the most important features in such neural recording, it is often enough to transmit information only related to the detected APs. This greatly reduces the data volume and enables low-power wireless links. However, for downstream processing and feature extraction, it is also important to preserve as much information about the APs as possible.

According to an exemplary embodiment of the present invention, during configuration, the circuit may receive the threshold **ThA** or thresholds for each of the sampling arrangements, which receive an analogue signal sensed by the corresponding electrodes. A 10b SAR ADC may be used and its supporting circuits (buffer, oscillator, SPI drivers) are all turned off unless they receive a 'wake-up' or activation signal. The analogue data from each electrode may be continuously sampled and buffered in an analogue FIFO. According to an exemplary embodiment, the signal threshold detection module **120** may comprise a dynamic comparator that checks the data for **ThA** crossing and generates the 'wake-up' call when the threshold is detected. Next, the ADC starts digitizing from the earliest stored sample, thus capturing the delayed pre-triggered AP data. Advantageously, according to an exemplary embodiment, the analogue FIFO is completely passive and uses capacitors and switches to store sampled data and deliver them to the ADC after a fixed delay (e.g. 250us). Since no data is generated unless an AP activity is detected, the microcontroller peripherals and the core processing units can go to sleep more often.

According to another exemplary embodiment, the proposed low-power method of AP detection and preservation of the wave shape uses an analogue sample-and-hold buffer. According to an exemplary embodiment, it is arranged as a circular FIFO (first-in-first-out) of depth 5. Here the data is continuously sampled and stored on different capacitors, and the first sampled data is sent out of the FIFO after 5 sampling cycles (e.g. equivalent to 250us, considering a 20kHz sampling frequency). In parallel, the sampled data is compared to a threshold value. A threshold crossing triggers the ADC and starts digitizing the earliest available sampled data, i.e., 250us before the threshold crossing (called pre-trigger). When the data is below the threshold value, the ADC and the ADC buffer are both turned off to save power. The core of the FIFO consist of a capacitor bank that uses appropriate clock cycles (Sa<1:5>) to store and release the analogue data. The sampled data (H<1:5>) is immediately compared to a threshold value, and the output of the comparator is used to trigger digitization. According to an exemplary embodiment, the time length of the AP digitized after the threshold crossing (post-trigger) can be adjusted.

The circuit and method according to an exemplary embodiment, is advantageously suited for tetrode-based applications, as shown in **Figure 4****.** Since all the four electrodes of a tetrode catches the same AP signal, one single ADC can be shared between them. Here we turn on the ADC when any one of the analogue FIFOs crosses the threshold. This further reduces power consumption of the complete system and has the potential to transmit better quality data for spike sorting purposes. According to an exemplary embodiment, various clock phases are required to multiplex multiple analog FIFOs on the same output line used by a single ADC and a single comparator. Since the electrodes in a tetrode record slightly different wave shapes, this method has the ability to provide threshold control for each individual electrode. It also has the capability to set up a dual-threshold AP detector that further reduces transmission volume (by discarding false positives). A capacitive DAC is used here to set the appropriate threshold values (for the dynamic comparator) at the beginning of each sampling cycle. In order to utilize the tetrode functionality, all four analogue FIFOs are interleaved together to use a single comparator and ADC. According to another exemplary embodiment, the analogue threshold to the comparator is continuously updated for each electrode **ThA<1:4>.**

## Claims

1. A circuit (10) for digitizing at least one analogue signal (Al), comprising:
a sample and hold module (100) configured for sampling the at least one analogue signal (Al) and storing a plurality of said sampled values (H1 to H5);
an analog-to-digital conversion module (150) configured for performing an analogue-to-digital conversion of the sampled values (H1 to H5) provided by the sample and hold module (100);
**characterized in that**
the sample and hold module (100) is further configured for providing to the analogue-to-digital conversion module (150) the stored sampled values (H1 to H5) in a first-input-first-output sequence; and
the circuit (10) further comprises a signal threshold detection module (120) configured for detecting whether any of the stored sampled values (H1 to H5) reaches or surpasses a certain threshold value (ThA) and generating a signal to activate the analog-to-digital conversion module (150) when said threshold is detected.

2. The circuit (10) according to claim 1 wherein the sampled values (H1 to H5) provided by the sample and hold module (100) for analogue-to-digital conversion represent a delayed quantized signal version of the at least one analogue signal (Al).

3. The circuit (10) according to any of the previous claims wherein the sample and hold module (100) is configured to continuously sample and store the sampled values of the at least one analogue signal (Al).

4. The circuit (10) according to any of the previous claims wherein the signal threshold detection module (120) is further configured for generating an indication to deactivate the analogue-to-digital conversion module (150) and stop conversion.

5. The circuit (10) according to any of the previous claims wherein the signal threshold detection module (120) comprises a comparator for comparing the stored sampled values (H1 to H5) with the threshold value (ThA).

6. The circuit (10) according to any of the previous claims wherein the stored sample values (H1 to H5) in the sample and hold module (100) are connected to the signal threshold detection module (120) by means of a multiplexer circuit.

7. The circuit (10) according to any of the previous claims wherein the sample and hold module (100) comprises at least one sampling arrangement (1 00a to 100d) configured as an analogue FIFO.

8. The circuit (10) according to claim 7 wherein the at least one sampling arrangement (110a to 100d) comprises a first set (S1 to S5) and a second set (S6 to S10) of switching elements being controlled by switching control signals (Sa<1> to Sa<5>) that trigger those switching elements (S1 to S5) in a sequential manner.

9. The circuit (10) according to any one of claims 7 or 8 wherein the sample and hold module (100) comprises a plurality of sampling arrangements (100a to 100d), each receiving a different input analogue signal (Al1 to Al4) to be digitized and the circuit being configured for interleaving in time the sampled analogue values (Aln(nTs)) provided to the signal threshold detection module (120) and to the analogue-to-digital conversion module (150).

10. An electronic system comprising a circuit (10) for digitizing at least one analogue signal (Al) according to any of claims 1 to 9.

11. A method for converting at least one analogue signal (Al) into a digital signal (DO), comprising:
in a sample and hold module (100), sampling the at least one analogue signal (Al), storing a plurality of said sampled values (H1 to H5) and providing to an analogue-to-digital conversion module (150) the stored sampled values (H1 to H5) according to a first-input-first-output sequence;
in a signal threshold detection module (120), detecting whether any of the stored sampled values (H1 to H5) reaches or surpasses a certain threshold value (ThA) and generating a signal to activate the analogue-to-digital conversion module (150) when said threshold is detected; and
in the analogue-to-digital conversion module (150), activating conversion circuitry and performing the analogue-to-digital conversion of the received sampled values (H1 to H5) when an activation signal is received from the signal threshold detection module (120).

12. The method of claim 11 wherein the sampling of the at least one analogue signal (Al) and the storing of the sampled values (H1 to H5) is performed continuously.

13. The method of claim 11 or 12 further comprising:
in the signal threshold detection module (120), generating an indication to deactivate the analogue-to-digital conversion module (150) and stop conversion: and
in the analogue-to-digital conversion module (150), deactivating conversion circuitry when an activation signal is received from the signal threshold detection module (120).

14. The method of any of claims 11 to 13 wherein:
in the sample and hold module (100), sampling a plurality of analogue signals (Al1 to Al4); and
interleaving in time the sampled analogue values (Aln(nTs)) provided to the signal threshold detection module (120) and to the analog-to-digital conversion module (150).
